# FASCICULE DE BREVET EUROPEEN

(11) **EP 3 377 670 B1**
(45) Date de publication et mention de la délivrance du brevet: **09.10.2019**
(21) Numéro de dépôt: 16815583.6
(22) Date de dépôt: 17.11.2016
(51) Int. Cl.: C23C 14/56, C23C 16/54

(54) **DISPOSITIF POUR LE REVÊTEMENT D'UN OU PLUSIEURS FILS PAR UN PROCÉDÉ DE DÉPÔT EN PHASE VAPEUR**
VORRICHTUNG ZUR BESCHICHTUNG EINES ODER MEHRERER DRÄHTE MITTELS GASPHASENABSCHEIDUNGSVERFAHREN
DEVICE FOR THE COATING OF ONE OR MORE WIRES USING A VAPOUR PHASE DEPOSITION METHOD

(30) Priorité: 19.11.2015 FR 1561149
(43) Date de publication de la demande: 26.09.2018
(73) Titulaire: Safran Ceramics, 33185 Le Haillan (FR)
(72) Inventeur: BUET, Emilien, 33160 Saint Medard en Jalles (FR); THIBAUD, Simon, 33650 La Brède (FR); DELCAMP, Adrien, 33700 Merignac (FR); DESCAMPS, Cédric, 33320 Eysines (FR)
(74) Mandataire: Cabinet Beau de Loménie
(86) Numéro de dépôt international: PCT/FR2016/052990
(87) Numéro de publication internationale: WO 2017/085412

(56) Documents cités:
- DE-U1- 9 421 895
- FR-A- 1 564 841
- FR-E- 91 083
- US-A1- 2007 099 527

## Description

### Arrière-plan de l'invention

L'invention concerne des dispositifs et procédés pour le revêtement d'un ou plusieurs fils par un procédé de dépôt en phase vapeur.

Les matériaux composites à matrice céramique (CMC) sont mis en oeuvre à des températures de fonctionnement relativement élevées. Ces matériaux comportent un renfort fibreux formé de fils en matériau céramique ou en carbone présent au sein d'une matrice céramique.

Lors de la réalisation de pièces en CMC, une texture fibreuse destinée à former le renfort fibreux de la pièce peut tout d'abord être obtenue par exemple par tissage tridimensionnel. Cette texture fibreuse est ensuite mise en forme afin d'obtenir une préforme fibreuse ayant une forme voisine de celle de la pièce à fabriquer. La préforme est alors densifiée afin de former la matrice et ainsi obtenir la pièce finale, la matrice peut par exemple être en tout ou partie formée par un procédé d'infiltration chimique en phase vapeur (« Chemical Vapor Infiltration » ; « CVI ») ou d'infiltration à l'état fondu (« Melt-Infiltration » ; « MI ») par exemple. Les fils peuvent avant l'étape de mise en forme textile (tissage, tressage...) avoir été revêtus d'un revêtement d'interphase permettant de retarder la rupture de fibres des fils par des fissures qui s'amorcent initialement au sein de la matrice. Le revêtement d'interphase de défragilisation peut, par exemple, être formé d'un matériau de structure lamellaire qui, lorsqu'une fissure parvient à l'interphase, est capable de dissiper l'énergie de fissuration par une déliaison localisée à l'échelle atomique de sorte que la fissure se trouve déviée au sein de l'interphase. Des matériaux constitutifs d'une interphase de défragilisation peuvent par exemple être le carbone pyrolytique (PyC) et le nitrure de bore (BN) qui présentent une structure lamellaire. Le revêtement d'interphase peut par exemple être formé par dépôt chimique en phase vapeur (« Chemical Vapor Déposition » ; « CVD »), infiltration chimique en phase vapeur (« Chemical Vapor Infiltration ») ou encore par voie liquide.

Des dispositifs aptes à réaliser le revêtement en continu d'une pluralité de fils par une interphase par dépôt chimique en phase vapeur ont été proposés dans la littérature. De tels dispositifs peuvent comporter une chambre de traitement au travers de laquelle une pluralité de fils à revêtir sont transportés par entrainement par un système de poulies. Un mélange réactif gazeux est injecté dans la chambre de traitement au travers d'un orifice d'entrée afin former sur les fils le revêtement d'interphase par dépôt chimique en phase vapeur. Le mélange réactif gazeux n'ayant pas réagi ainsi que les sous-produits de réaction sont pompés au travers d'un orifice de sortie lequel est décalé de l'orifice d'entrée le long de l'axe longitudinal de la chambre de traitement. Des revêtements d'interphase multicouches peuvent être réalisés en plaçant en série plusieurs unités de ce type comprenant un dispositif d'injection d'une phase gazeuse ainsi qu'un dispositif d'évacuation de la phase gazeuse résiduelle.

Il serait toutefois souhaitable de fournir des dispositifs compacts permettant de réaliser un revêtement multicouches par dépôt en phase vapeur sur un ou plusieurs fils. En outre, il peut être souhaitable de fournir des dispositifs permettant d'augmenter le nombre de fils pouvant être traités par unité de temps.

On connait en outre le document FR 91 083 qui décrit un procédé pour le traitement des surfaces des matières textiles et les documents FR 1 564 841, US 2007/0099527 et DE 94 21 895 qui décrivent des procédés de revêtement de fibres.

Il existe donc un besoin pour fournir des dispositifs compacts permettant de réaliser un revêtement multicouches par dépôt en phase vapeur sur un ou plusieurs fils.

Il existe en outre un besoin pour fournir des dispositifs permettant d'augmenter le nombre de fils pouvant être traités par unité de temps.

### Objet et résumé de l'invention

A cet effet, l'invention propose, selon un premier aspect, un dispositif pour le revêtement d'un ou plusieurs fils par un procédé de dépôt en phase vapeur, comportant au moins :
- une chambre de traitement définissant au moins une première zone de traitement et une deuxième zone de traitement dans lesquelles au moins un fil est destiné à être revêtu par mise en oeuvre d'un procédé de dépôt en phase vapeur, les première et deuxième zones étant séparées par une paroi et la première zone entourant la deuxième zone ou étant superposée à la deuxième zone,
- un système de convoyage configuré pour réaliser le transport dudit au moins un fil au travers des première et deuxième zones,
- un premier dispositif d'injection configuré pour injecter une première phase gazeuse de traitement dans la première zone ainsi qu'un premier dispositif d'évacuation configuré pour évacuer la première phase gazeuse résiduelle hors de la première zone, et
- un deuxième dispositif d'injection configuré pour injecter une deuxième phase gazeuse de traitement dans la deuxième zone ainsi qu'un deuxième dispositif d'évacuation configuré pour évacuer la deuxième phase gazeuse résiduelle hors de la deuxième zone.

L'invention fournit avantageusement des dispositifs compacts permettant de réaliser un revêtement multicouches par dépôt en phase vapeur sur un ou plusieurs fils.

Dans un exemple de réalisation, le système de convoyage peut être configuré pour réaliser en continu le transport dudit au moins un fil au travers des première et deuxième zones. En d'autres termes, dans ce cas, le système de convoyage est configuré pour que ledit au moins un fil ne s'arrête pas lors de son trajet au travers des première et deuxième zones. Dans ce cas, ledit au moins un fil est animé d'une vitesse non nulle sur toute la durée de son trajet au travers des première et deuxième zones.

Le dispositif peut en outre comporter un système de chauffage configuré pour chauffer les première et deuxième zones de traitement.

Dans un exemple de réalisation, la première zone peut s'étendre le long d'un premier axe longitudinal et au moins un premier canal d'injection peut déboucher dans la première zone, ledit premier canal d'injection pouvant être configuré pour injecter une partie au moins de la première phase gazeuse dans la première zone selon une première direction d'injection non parallèle au premier axe longitudinal.

Une telle caractéristique permet d'améliorer le remplissage de la section de la première zone par la première phase gazeuse et permet ainsi d'améliorer encore la qualité du dépôt formé sur le ou les fils.

Dans un exemple de réalisation, la première direction d'injection forme un angle compris entre 30° et 60° avec le premier axe longitudinal.

Une telle caractéristique permet d'améliorer encore la qualité du dépôt formé sur le ou les fils.

En variante, la première direction d'injection peut être sensiblement parallèle au premier axe longitudinal.

Dans un exemple de réalisation, la deuxième zone peut s'étendre le long d'un deuxième axe longitudinal et au moins un deuxième canal d'injection peut déboucher dans la deuxième zone, ledit deuxième canal d'injection pouvant être configuré pour injecter une partie au moins de la deuxième phase gazeuse dans la deuxième zone selon une deuxième direction d'injection non parallèle au deuxième axe longitudinal.

Une telle caractéristique permet d'améliorer le remplissage de la section de la deuxième zone par la deuxième phase gazeuse et permet ainsi d'améliorer encore la qualité du dépôt formé sur le ou les fils.

Dans un exemple de réalisation, la deuxième direction d'injection forme un angle compris entre 30° et 60° avec le deuxième axe longitudinal.

Une telle caractéristique permet d'améliorer encore la qualité du dépôt formé sur le ou les fils.

Dans un exemple de réalisation, la première zone peut s'étendre le long d'un premier axe longitudinal et le premier dispositif d'injection peut présenter des orifices d'injection débouchant dans la première zone, ces orifices d'injection étant décalés le long du premier axe longitudinal.

Il est possible d'injecter dans la première zone une partie distincte de la première phase gazeuse au travers de chacun des orifices d'injection du premier dispositif d'injection.

Dans un exemple de réalisation, la deuxième zone peut s'étendre le long d'un deuxième axe longitudinal et le deuxième dispositif d'injection peut présenter des orifices d'injection débouchant dans la deuxième zone, ces orifices d'injection étant décalés le long du deuxième axe longitudinal.

Il est possible d'injecter dans la deuxième zone une partie distincte de la deuxième phase gazeuse au travers de chacun des orifices d'injection du deuxième dispositif d'injection.

Le fait d'injecter une phase gazeuse en plusieurs parties au travers d'orifices d'injection décalés le long de l'axe longitudinal d'une zone de traitement permet avantageusement de réduire la génération de solides indésirables hors de la zone utile et ainsi d'améliorer encore la qualité du dépôt formé.

Dans un exemple de réalisation, la paroi est revêtue d'une couche réfléchissant le rayonnement infrarouge.

Par « couche réfléchissant le rayonnement infrarouge », il faut comprendre une couche présentant un coefficient de réflexion moyen compris entre 5% et 50% sur le domaine de longueur d'onde compris entre 1000 nm et 8000 nm. La présence d'une telle couche permet de contrôler la température imposée dans la deuxième zone sans avoir à placer un système de chauffage dans la deuxième zone. L'épaisseur de la couche réfléchissant le rayonnement infrarouge peut être comprise entre 0,001 mm et 1 mm. En modifiant l'épaisseur de la couche, il est possible de moduler son coefficient de réflexion du rayonnement infrarouge.

La couche réfléchissant le rayonnement infrarouge peut par exemple être en oxyde d'indium, en oxyde d'étain ou en oxyde indium-étain (« Indium Tin Oxide »).

Dans un exemple de réalisation, la première zone peut entourer la deuxième zone et le système de convoyage peut en outre être configuré pour positionner les fils à traiter de manière circonférentielle dans chacune des première et deuxième zones.

Un tel positionnement des fils le long de la circonférence des zones de traitement permet d'augmenter la quantité de fils traités par unité de temps par rapport au cas où ces fils sont positionnés de manière rectiligne.

Dans un exemple de réalisation, le système de convoyage peut comporter un élément de réglage de la vitesse de défilement dudit au moins un fil au travers de la chambre de traitement.

Une telle caractéristique permet avantageusement de facilement faire varier l'épaisseur des couches formées en modifiant la vitesse de défilement dudit au moins un fil au travers de la chambre de traitement.

La présente invention vise également un procédé de revêtement d'un ou plusieurs fils par un procédé de dépôt en phase vapeur mettant en oeuvre un dispositif tel que décrit plus haut, le procédé comportant au moins les étapes suivantes :
- injection de la première phase gazeuse dans la première zone et de la deuxième phase gazeuse dans la deuxième zone,
- transport d'au moins un fil par le système de convoyage dans la chambre de traitement durant lequel :
   ▪ ledit au moins un fil traverse la première zone, respectivement la deuxième zone, afin de former une première couche sur ledit au moins un fil par dépôt en phase vapeur à partir de la première phase gazeuse, respectivement de la deuxième phase gazeuse, puis
   ▪ ledit au moins un fil revêtu de la première couche traverse la deuxième zone, respectivement la première zone, afin de former une deuxième couche sur ladite première couche par dépôt en phase vapeur à partir de la deuxième phase gazeuse, respectivement de la première phase gazeuse, et
   ▪ évacuation de la première phase gazeuse résiduelle hors de la première zone et de la deuxième phase gazeuse résiduelle hors de la deuxième zone.

La formation des première et deuxième couches peut avoir lieu alors que ledit au moins un fil est mis en mouvement par le système de convoyage au travers de la chambre de traitement.

Le procédé de dépôt en phase vapeur mis en oeuvre peut être un dépôt chimique en phase vapeur (« CVD »), un dépôt chimique en phase vapeur réactive (« Reactive Chemical Vapor Déposition » ; « RCVD ») ou un dépôt physique en phase vapeur (« Physical Vapor Déposition » ; « PVD »).

Dans un exemple de réalisation, ledit au moins un fil peut être transporté en continu par le système de convoyage dans la chambre de traitement.

Dans un exemple de réalisation, la première couche et/ou la deuxième couche peuvent être formées par dépôt chimique en phase vapeur (addition de matière sur la surface des fils) ou par dépôt chimique en phase vapeur réactive (transformation de la matière présente à la surface des fils).

Dans un exemple de réalisation, les première et deuxième couches peuvent chacune être une couche d'un revêtement d'interphase.

La couche d'un revêtement d'interphase est, par exemple, en pyrocarbone (PyC), nitrure de bore (BN), carbone dopé au bore (BC), nitrure de silicium (Si₃N₄), ou en un carbure mixte de bore et silicium (Si-B-C).

La présente invention vise également un procédé de fabrication d'une pièce en matériau composite comportant au moins les étapes suivantes :
- revêtement d'une pluralité de fils par un revêtement d'interphase au moins par mise en oeuvre d'un procédé tel que décrit plus haut,
- formation d'une préforme fibreuse au moins par mise en oeuvre d'une ou plusieurs opérations textiles à partir des fils ainsi revêtus par le revêtement d'interphase, et
- densification de la préforme fibreuse par une matrice afin d'obtenir une pièce en matériau composite.

De préférence, la préforme fibreuse est obtenue par tissage, par exemple par tissage tridimensionnel, à partir des fils revêtus par le revêtement d'interphase.

La matrice peut comporter un matériau céramique comme du carbure de silicium ou être en carbone. La matrice peut être formée par tout type de procédé connu comme l'infiltration chimique en phase vapeur (« Chemical Vapor Infiltration ») ou l'infiltration à l'état fondu (« Melt-Infiltration »), par exemple.

La pièce formée peut, par exemple, être une aube de turbomachine ou un secteur d'anneau de turbine, par exemple.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- la figure 1 représente de manière schématique une coupe longitudinale d'un exemple de dispositif selon l'invention,
- la figure 2 représente de manière schématique et partielle une section transversale du dispositif de la figure 1,
- la figure 3 représente de manière schématique une coupe longitudinale d'une variante de dispositif selon l'invention,
- la figure 4 représente de manière schématique et partielle une section transversale d'une autre variante de dispositif selon l'invention, et
- la figure 5 représente de manière schématique et partielle une coupe longitudinale du dispositif illustré de la figure 4.

### Description détaillée de modes de réalisation

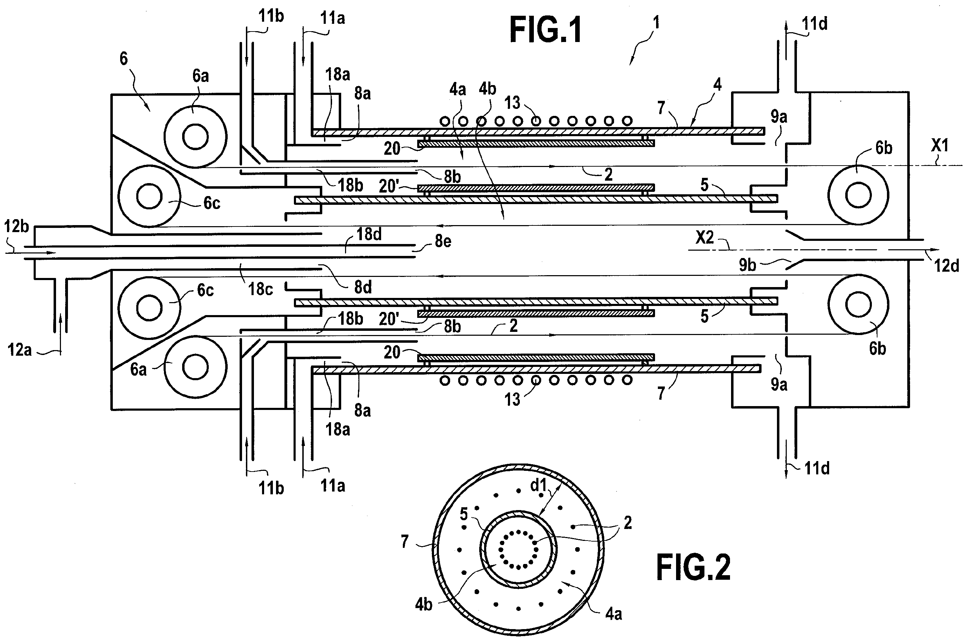

On a représenté à la figure 1 un dispositif 1 selon l'invention permettant le revêtement d'une pluralité de fils 2 par un procédé de dépôt en phase vapeur. Comme illustré à la figure 1, le dispositif 1 comporte une chambre de traitement 4 définissant au moins une première 4a et une deuxième 4b zones de traitement dans lesquelles les fils 2 sont destinés à être revêtus par mise en oeuvre d'un procédé de dépôt en phase vapeur. Les fils 2 destinés à être revêtus ne sont pas liés entre eux (en particulier ces fils ne sont pas tissés, tricotés ou tressés). Ces fils 2 n'ont pas subi d'opération textile et ne forment pas une structure fibreuse. Une couche distincte est formée par un procédé de dépôt en phase vapeur dans chacune de ces zones 4a et 4b. Le dispositif 1 illustré à la figure 1 permet de former un revêtement bicouches sur les fils 2 par dépôt en phase vapeur. Les fils 2 peuvent être formés d'un matériau céramique, par exemple d'un matériau oxyde, nitrure, carbure, par exemple de carbure de silicium (SiC). En variante, les fils 2 peuvent être des fils de carbone. Dans un exemple de réalisation, une partie des fils 2 est formée d'un matériau céramique et une partie des fils 2 est en carbone. Dans un exemple de réalisation, au moins 20 fils, par exemple entre 20 et 200 fils peuvent être traités simultanément. Dans l'exemple illustré, la première zone 4a entoure la deuxième zone 4b et est séparée de celle-ci par une paroi circonférentielle interne 5. La première zone 4a s'étend selon un premier axe longitudinal X₁. La première zone de traitement 4a est présente entre une paroi circonférentielle interne 5 et une paroi circonférentielle externe 7. La première zone 4a est de forme annulaire lorsqu'observée en section perpendiculairement au premier axe longitudinal X₁. Dans l'exemple illustré aux figures 1 et 2, la première zone 4a a une forme générale circulaire lorsqu'observée en section perpendiculairement au premier axe longitudinal. On ne sort toutefois pas du cadre de l'invention lorsque la première zone a une autre forme comme une forme générale elliptique ou polygonale, par exemple rectangulaire ou carrée, lorsqu'observée en section perpendiculairement au premier axe longitudinal. La deuxième zone 4b s'étend selon un deuxième axe longitudinal X₂ lequel est dans l'exemple illustré parallèle au premier axe longitudinal X₁. Dans l'exemple illustré aux figures 1 et 2, la deuxième zone 4b a une forme générale circulaire lorsqu'observée en section perpendiculairement au deuxième axe longitudinal. On ne sort toutefois pas du cadre de l'invention lorsque la deuxième zone a une autre forme comme une forme générale elliptique ou polygonale, par exemple rectangulaire ou carrée, lorsqu'observée en section perpendiculairement au deuxième axe longitudinal. Dans l'exemple illustré, la paroi circonférentielle interne 5 et la paroi circonférentielle externe 7 sont concentriques (voir figure 2). La distance d₁ entre la paroi circonférentielle interne 5 et la paroi circonférentielle externe 7 peut être supérieure ou égale à 0,02 m (voir figure 2). Cette distance d₁ peut être inférieure ou égale à 0,1 m et par exemple être comprise entre 0,02 m et 0,1 m. La distance d₁ est mesurée perpendiculairement au premier axe longitudinal X₁.

Les fils 2 sont répartis de manière circonférentielle dans les première et deuxième zones 4a et 4b (voir figure 2). Une telle répartition des fils 2 permet avantageusement d'augmenter le nombre de fils traités par unité de temps par rapport à une répartition rectiligne des fils.

Le système de convoyage 6 est configuré pour réaliser le transport des fils au travers des première 4a et deuxième 4b zones. Plus précisément, le système de convoyage 6 est, dans l'exemple illustré à la figure 1, configuré pour réaliser le transport des fils 2 au travers successivement de la première zone 4a et de la deuxième zone 4b. Ainsi, dans l'exemple illustré, les fils 2 sont transportés par le système de convoyage 6 au travers de la première zone 4a puis au travers de la deuxième zone 4b. En variante, le système de convoyage peut être configuré pour réaliser le transport des fils au travers successivement de la deuxième zone et de la première zone (les fils traversent d'abord la deuxième zone puis la première zone).

Le système de convoyage 6 comprend, dans l'exemple illustré, un premier ensemble de poulies 6a, un deuxième ensemble de poulies 6b et un troisième ensemble de poulies 6c. Les premier 6a, deuxième 6b et troisième 6c ensembles de poulies sont chacun positionnés, dans l'exemple illustré, de manière annulaire autour du deuxième axe longitudinal X₂. Les poulies 6a du premier ensemble sont positionnées de manière annulaire autour du deuxième axe longitudinal X₂. Les poulies 6b du deuxième ensemble sont positionnées de manière annulaire autour du deuxième axe longitudinal X₂. Les poulies 6c du troisième ensemble sont positionnées de manière annulaire autour du deuxième axe longitudinal X₂. Les poulies 6a du premier ensemble et les poulies 6b du deuxième ensemble sont configurées pour transporter les fils au travers de la première zone 4a. Les poulies 6b du deuxième ensemble et les poulies 6c du troisième ensemble sont configurées pour transporter les fils 2 au travers de la deuxième zone 4b.

Le système de convoyage 6 est configuré pour que les fils 2 effectuent deux passages successifs au travers de la chambre de traitement 4. Dans l'exemple illustré, les fils 2 à traiter, transportés par les poulies des premier et deuxième ensembles, effectuent tout d'abord un premier passage au travers de la première zone 4a puis ces fils 2, transportés par les poulies des deuxième et troisième ensembles, effectuent un deuxième passage au travers de la deuxième zone 4b.

Le dispositif 1 comporte en outre un premier dispositif d'injection configuré pour injecter une première phase gazeuse de traitement dans la première zone 4a ainsi qu'un premier dispositif d'évacuation configuré pour évacuer la première phase gazeuse résiduelle 11d hors de la première zone 4a. Le premier dispositif d'évacuation est configuré pour évacuer la première phase gazeuse résiduelle 11d hors de la chambre de traitement 4 au travers d'un ou plusieurs orifices de sortie 9a. Afin de réaliser l'évacuation de la première phase gazeuse résiduelle 11d, le ou les orifices de sortie 9a sont en relation avec des moyens d'aspiration tels qu'une pompe à vide (non représentée).

Le premier dispositif d'injection présente en outre au moins un premier 8a et un deuxième 8b orifices d'injection décalés le long du premier axe longitudinal X₁ et débouchant dans la première zone 4a. Avantageusement, une première partie 11a de la première phase gazeuse peut être injectée dans la première zone 4a au travers du premier orifice d'injection 8a et une deuxième partie 11b de la première phase gazeuse, différente de la première, peut être injectée dans la première zone 4a au travers du deuxième orifice d'injection 8b. Le premier dispositif d'injection comporte, dans l'exemple illustré, une pluralité de couples de tels premier 8a et deuxième 8b orifices d'injection. On ne sort pas du cadre de la présente invention lorsque le premier dispositif d'injection comporte un unique orifice d'injection au travers duquel la première phase gazeuse est injectée dans la première zone, cet orifice pouvant par exemple avoir une forme annulaire.

Dans l'exemple illustré à la figure 1, le premier dispositif d'injection comporte une pluralité de premiers canaux d'injection 18a débouchant chacun dans la première zone 4a au travers d'un premier orifice d'injection 8a et une pluralité de deuxième canaux d'injection 18b débouchant chacun dans la première zone 4a au travers d'un deuxième orifice d'injection 8b. Les premiers canaux d'injection 18a sont configurés pour injecter une partie de la première phase gazeuse 11a distincte de celle 11b destinée à être injectée au travers des deuxièmes canaux d'injection 18b. L'injection au travers des premiers 18a et deuxièmes 18b canaux est effectuée selon une direction d'injection sensiblement parallèle au premier axe longitudinal X₁. Un élément répartiteur du flux gazeux permettant de répartir sur la section de la première zone 4a les phases gazeuses 11a et 11b injectées peut être positionné en sortie des canaux 18a et 18b.

Le dispositif 1 comporte en outre un deuxième dispositif d'injection configuré pour injecter une deuxième phase gazeuse de traitement dans la deuxième zone 4b ainsi qu'un deuxième dispositif d'évacuation configuré pour évacuer la deuxième phase gazeuse résiduelle 12d hors de la deuxième zone 4b. Le deuxième dispositif d'évacuation est configuré pour évacuer la deuxième phase gazeuse résiduelle 12d hors de la chambre de traitement 4 au travers d'un ou plusieurs orifices de sortie 9b. Afin de réaliser l'évacuation de la deuxième phase gazeuse résiduelle 12d, le ou les orifices de sortie 9b sont en relation avec des moyens d'aspiration tels qu'une pompe à vide (non représentée).

Le deuxième dispositif d'injection présente au moins un premier 8d et un deuxième 8e orifices d'injection décalés le long du deuxième axe longitudinal X₂ et débouchant dans la deuxième zone 4b. Avantageusement, une première partie 12a de la deuxième phase gazeuse peut être injectée dans la deuxième zone 4b au travers du premier orifice d'injection 8d et une deuxième partie 12b de la deuxième phase gazeuse, différente de la première, peut être injectée dans la deuxième zone 4b au travers du deuxième orifice d'injection 8e. Le deuxième dispositif d'injection peut dans un exemple de réalisation comporter une pluralité de couples de tels premier et deuxième orifices d'injection. On ne sort pas du cadre de la présente invention lorsque le deuxième dispositif d'injection comporte un unique orifice d'injection au travers duquel la deuxième phase gazeuse est injectée dans la deuxième zone 4b.

Le deuxième dispositif d'injection comporte un premier canal d'injection 18c débouchant dans la deuxième zone 4b au travers du premier orifice d'injection 8d et un deuxième canal d'injection 18d débouchant dans la deuxième zone 4b au travers du deuxième orifice d'injection 8e. Dans l'exemple illustré, le premier canal d'injection 18c du deuxième dispositif d'injection et le deuxième canal d'injection 18d du deuxième dispositif d'injection sont chacun configurés pour injecter une partie distincte de la deuxième phase gazeuse dans la deuxième zone 4b selon une direction d'injection sensiblement parallèle au deuxième axe longitudinal X₂. Comme décrit plus haut relativement à la première zone 4a, un élément répartiteur du flux gazeux permettant de répartir sur la section de la deuxième zone 4b les phases gazeuses 12a et 12b injectées peut être positionné en sortie des canaux 18c et 18d.

Le dispositif 1 comprend en outre un système de chauffage configuré pour chauffer les première 4a et deuxième 4b zones de traitement afin de réaliser le dépôt en phase vapeur. Plus précisément, le système de chauffage comporte un premier suscepteur 20, un deuxième suscepteur 20' ainsi qu'un inducteur 13. Les suscepteurs 20 et 20' sont couplés inductivement avec l'inducteur 13 lequel est situé à l'extérieur de la chambre de traitement 4. Les premier 20 et deuxième 20' suscepteurs sont présents, dans l'exemple illustré, à l'intérieur de la chambre de traitement 4 dans la première zone 4a. Les premier 20 et deuxième 20' suscepteurs sont de forme annulaire. Le premier suscepteur 20 est situé du côté de la paroi circonférentielle externe 7 et le deuxième suscepteur 20' est situé du côté de la paroi circonférentielle interne 5. La première zone 4a est délimitée radialement par les premier 20 et deuxième 20' suscepteurs. La première zone 4a est située entre les premier 20 et deuxième 20' suscepteurs.

Dans une variante non illustrée, le dispositif comporte un inducteur ainsi qu'un unique suscepteur lequel peut être situé à l'intérieur de la chambre de traitement ou à l'extérieur de celle-ci.

La paroi circonférentielle interne 5 est revêtue d'un matériau réflecteur du rayonnement infrarouge. Cela permet avantageusement de contrôler la température imposée dans la deuxième zone 4b sans avoir à placer un suscepteur dans ladite deuxième zone 4b. Une telle caractéristique contribue ainsi à simplifier la structure du dispositif 1.

Afin de réaliser le revêtement de fils 2 par un revêtement d'interphase, il est possible de mettre en oeuvre le procédé suivant. Les fils 2 sont tout d'abord transportés au travers de la première zone 4a. Une partie de la première phase gazeuse est injectée au travers des premiers orifices d'injection 8a et une autre partie de la première phase gazeuse est injectée au travers des deuxièmes orifices d'injection 8b alors que les fils 2 sont transportés continûment au travers de la première zone 4a. Ces deux parties injectées se mélangent dans la zone utile afin de former la première phase gazeuse. Une première couche d'un revêtement d'interphase est alors formée sur les fils 2 lors de leur transport au travers de la première zone 4a par dépôt chimique en phase vapeur à partir de la première phase gazeuse. La première phase gazeuse s'écoule selon le premier axe longitudinal X₁ du fait de l'aspiration réalisée au niveau des orifices de sortie 9a.

Les fils revêtus de la première couche du revêtement d'interphase sont ensuite transportés par le système de convoyage 6 jusqu'à la deuxième zone de traitement 4b. Le système de convoyage 6 est comme illustré configuré pour faire effectuer aux fils un demi-tour (inversion du sens du trajet des fils). Une deuxième phase gazeuse de traitement est injectée dans cette deuxième zone 4b par le deuxième dispositif d'injection afin de former sur les fils revêtus de la première couche une deuxième couche d'un revêtement d'interphase par dépôt chimique en phase vapeur. Comme pour la première phase gazeuse, une partie de la deuxième phase gazeuse 12a est injectée au travers du premier orifice d'injection 8d et une autre partie de la deuxième phase gazeuse 12b est injectée au travers du deuxième orifice d'injection 8e alors que les fils 2 sont transportés continûment au travers de la deuxième zone 4b. La deuxième phase gazeuse résiduelle 12d est évacuée au travers de l'orifice de sortie 9b. La deuxième couche peut être formée d'un matériau identique ou différent de celui formant la première couche. La température imposée dans la première zone 4a peut être différente de la température imposée dans la deuxième zone 4b. En variante, la température imposée dans la première zone 4a est sensiblement égale à la température imposée dans la deuxième zone 4b.

Les phases gazeuses permettant de former le dépôt chimique en phase vapeur comprennent un ou plusieurs précurseurs du matériau de la couche à former. Lorsqu'un revêtement d'interphase en carbone est destiné à être formé, les phases gazeuses peuvent comporter un ou plusieurs hydrocarbures gazeux, par exemple choisis parmi le méthane, l'éthane, le propane et le butane. Les phases gazeuses peuvent en variante comporter un précurseur gazeux d'un matériau céramique comme du méthyltrichlorosilane. Afin de réaliser un dépôt donné, le choix du ou des précurseurs à mettre en oeuvre ainsi que les conditions de pression et de température à imposer dans les première et deuxième zones de traitement font partie des connaissances générales de l'homme du métier.

Comme mentionné plus haut, le système de convoyage 6 peut avantageusement comporter un élément de réglage de la vitesse de défilement des fils 2 au travers de la chambre de traitement 4. En faisant varier la vitesse de défilement des fils 2, un utilisateur peut ainsi modifier le temps de séjour des fils dans les zones de traitement et par conséquent modifier l'épaisseur de la ou des couches formées sur les fils. Une fois la vitesse de défilement fixée, l'homme du métier est en mesure de déterminer à partir de ses connaissances générales les valeurs des débits des phases gazeuses à mettre en oeuvre afin d'obtenir le dépôt en phase vapeur recherché.

La vitesse de défilement imposée aux fils 2 durant tout ou partie de leur trajet au travers de la chambre de traitement 4 peut être supérieure ou égale à 0,01 mètre/minute. La vitesse de défilement imposée aux fils 2 durant tout ou partie de leur trajet au travers de la chambre de traitement 4 peut être inférieure ou égale à 5 mètres/minute et par exemple être comprise entre 0,01 mètre/minute et 5 mètres/minute. A titre d'exemple, le débit de la première phase gazeuse injectée et/ou le débit de la deuxième phase gazeuse injectée peut être supérieur ou égal à 0,5 litre/minute, par exemple compris entre 0,5 litre/minute et 5 litres/minute. Lorsqu'une partie d'une phase gazeuse est injectée au travers d'un orifice d'injection et lorsqu'une autre partie de la phase gazeuse est injectée au travers d'un autre orifice d'injection, le débit de ladite phase gazeuse est égal à la somme des débits des différentes parties de ladite phase gazeuse injectées.

Dans une variante non illustrée, la chambre de traitement définit au moins trois zones de traitement concentriques afin de former un revêtement comprenant au moins trois couches.

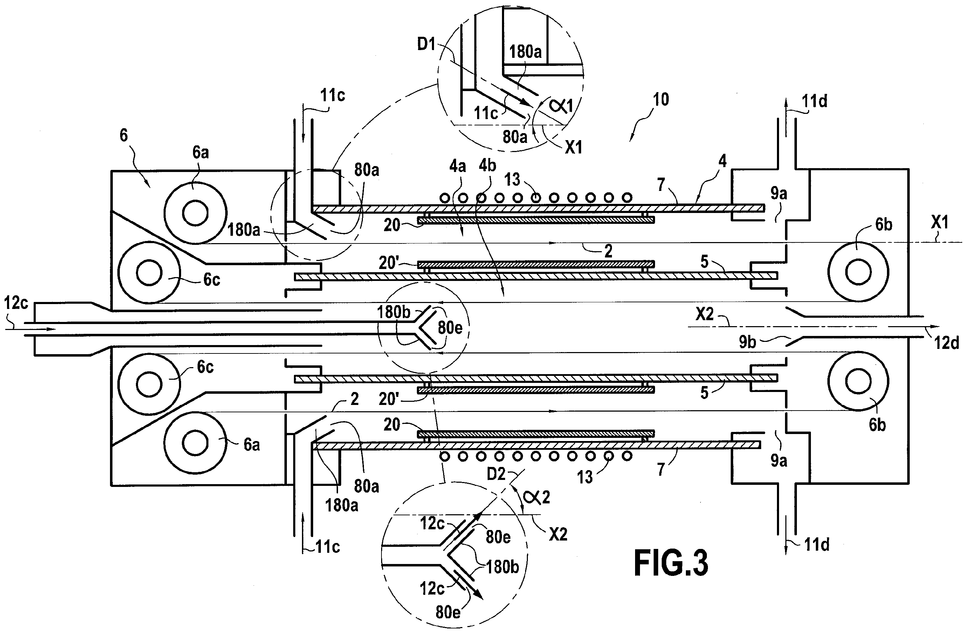

On a représenté à la figure 3 une variante de dispositif 10 selon l'invention dans lequel une pluralité de canaux d'injection 180a débouchent dans la première zone 4a au travers d'orifices 80a. Chaque canal d'injection 180a est configuré pour injecter la première phase gazeuse 11c dans la première zone 4a selon une direction d'injection (notée D₁ pour un des canaux d'injection 180a) non parallèle au premier axe longitudinal X₁. Comme mentionné plus haut, une telle caractéristique permet d'améliorer le remplissage de la section de la première zone 4a par la première phase gazeuse 11c et ainsi d'améliorer encore la qualité du dépôt formé sur le ou les fils. La direction d'injection D₁ forme dans l'exemple illustré un angle α₁ compris entre 30° et 60° avec le premier axe longitudinal X₁. De la même manière, le dispositif 10 comporte une pluralité de canaux d'injection 180b débouchant dans la deuxième zone 4b au travers d'orifices 80e. Chaque canal d'injection 180b est configuré pour injecter la deuxième phase gazeuse 12c dans la deuxième zone 4b selon une direction d'injection (notée D₂ pour un des canaux d'injection 180b) non parallèle au deuxième axe longitudinal X₂. Comme mentionné plus haut, une telle caractéristique permet d'améliorer le remplissage de la section de la deuxième zone 4b par la deuxième phase gazeuse 12c et ainsi d'améliorer encore la qualité du dépôt formé sur le ou les fils. La direction d'injection D₂ forme dans l'exemple illustré un angle α₂ compris entre 30° et 60° avec le deuxième axe longitudinal X₂.

On ne sort pas du cadre de l'invention lorsque le dispositif comporte des canaux d'injection permettant chacun d'injecter une partie seulement de la phase gazeuse de traitement dans une zone de traitement avec un angle non nul par rapport à l'axe longitudinal de ladite zone de traitement.

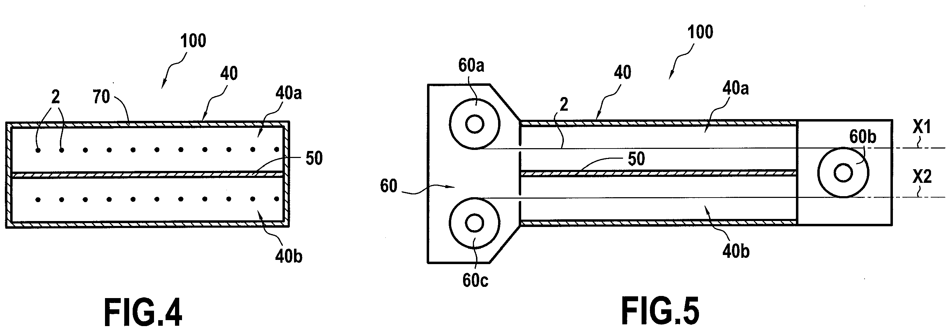

La figure 4 illustre une variante de dispositif 100 selon l'invention dans lequel la première zone 40a est superposée à la deuxième zone 40b. Les première 40a et deuxième 40b zones sont séparées par la paroi 50. La chambre de traitement 40 est quant à elle délimitée par la paroi 70. Dans l'exemple illustré à la figure 4, la première zone 40a a une forme générale rectangulaire lorsqu'observée en section perpendiculairement à son axe longitudinal X₁. La deuxième zone 40b a elle aussi une forme générale rectangulaire lorsqu'observée en section perpendiculairement à son axe longitudinal X₂. On ne sort pas du cadre de l'invention lorsque les sections des première et deuxième zones ont des formes différentes. Comme illustré à la figure 5, le système de convoyage 60 comprend un premier ensemble de poulies 60a, un deuxième ensemble de poulies 60b et un troisième ensemble de poulies 60c. Les poulies 60a du premier ensemble et les poulies 60b du deuxième ensemble sont configurées pour transporter les fils au travers de la première zone 40a. Les poulies 60b du deuxième ensemble et les poulies 60c du troisième ensemble sont configurées pour transporter les fils 2 au travers de la deuxième zone 40b.

Le système de convoyage 60 est configuré pour faire effectuer aux fils 2 deux passages successifs au travers de la chambre de traitement 40. Dans l'exemple illustré, les fils 2, transportés par les poulies des premier et deuxième ensembles, effectuent tout d'abord un premier passage au travers de la première zone 40a puis les fils 2, transportés par les poulies des deuxième et troisième ensembles, effectuent un deuxième passage au travers de la deuxième zone 40b. Dans l'exemple illustré à la figure 5, l'axe longitudinal X₂ de la deuxième zone de traitement 40b est parallèle à l'axe longitudinal X₁ de la première zone de traitement 40a. On ne sort pas du cadre de l'invention lorsque l'axe longitudinal de la première zone de traitement forme un angle non nul avec l'axe longitudinal de la deuxième zone de traitement.

### Exemple

Un revêtement d'interphase bi-couches de nitrure de bore et de carbure de silicium a été déposé par un procédé de dépôt en phase vapeur sur une pluralité de fils défilant dans une chambre de traitement du type de celle illustrée à la figure 1. Les fils sont des fils de carbone ou des fils en matériau céramique (fils SiC ou Si-C-O, comme des fils Nicalon®, Hi-Nicalon® ou Hi-Nicalon® Type S de la société Nippon Carbon). Une première phase gazeuse de traitement a été injectée dans la première zone de traitement 4a et une deuxième phase gazeuse de traitement a été injectée dans la deuxième zone de traitement 4b. Le diamètre de la paroi circonférentielle externe 7 était de 0,5 m et le diamètre de la paroi circonférentielle interne 5 de 0,45 m. La valeur de la vitesse de défilement des fils dans les première et deuxième zones de traitement a été imposée à 100 millimètres/minute. La longueur de chauffe (i.e. la longueur des suscepteurs) était de 500 mm. La paroi circonférentielle interne 5 a été recouverte d'une couche d'oxyde indium-étain (matériau réflecteur de l'infrarouge) présentant une épaisseur égale à 0,002 mm.

Les paramètres suivants ont été imposés pour réaliser le dépôt en phase vapeur dans la première zone de traitement 4a (relatif à la première phase gazeuse) :
- température de 1100 °C,
- coefficient alpha (correspondant au rapport (débit volumique de NH₃)/(débit volumique de BCl₃)) de 1,3,
- coefficient bêta (correspondant au rapport (débit volumique de H₂)/(débit volumique de BCl₃ + débit volumique de NH₃)) de 1,
- pression totale de 0,2 kPa,
- temps de séjour de 87 millisecondes,
- durée du traitement de 300 minutes.

Plus précisément, les débits suivants ont été imposés pour la première phase gazeuse de traitement :
- H₂ : 1,69 L/min
- NH₃ : 0,95 L/min
- BCl₃ : 0,73 L/min
- Total : 3,38 L/min

Les paramètres suivants ont été imposés pour réaliser le dépôt en phase vapeur dans la deuxième zone de traitement 4b (relatif à la deuxième phase gazeuse) :
- température de 1000 °C,
- coefficient alpha (correspondant au rapport (débit volumique de H₂)/(débit volumique de MTS)) de 8,
- pression totale de 100 kPa,
- temps de séjour de 2000 millisecondes,
- durée du traitement de 300 minutes.

Plus précisément, les débits suivants ont été imposés pour la deuxième phase gazeuse de traitement :
- H₂ : 3,2 L/min
- MTS : 0,4 L/min

Ces conditions de traitement ont permis d'obtenir un revêtement d'interphase bi-couches de niture de bore et carbure de silicium ayant une épaisseur totale de l'ordre de 300 nm.

L'expression « compris(e) entre ... et ... » ou « allant de ... à ... » doit se comprendre comme incluant les bornes.

## Revendications

1. Dispositif (1 ; 10 ; 100) pour le revêtement d'un ou plusieurs fils (2) par un procédé de dépôt en phase vapeur, comportant au moins :
- une chambre de traitement (4 ; 40) définissant au moins une première zone de traitement (4a ; 40a) et une deuxième zone de traitement (4b ; 40b) dans lesquelles au moins un fil (2) est destiné à être revêtu par mise en oeuvre d'un procédé de dépôt en phase vapeur, les première et deuxième zones étant séparées par une paroi (5 ; 50) et la première zone entourant la deuxième zone ou étant superposée à la deuxième zone,
- un système de convoyage (6 ; 60) configuré pour réaliser le transport dudit au moins un fil (2) au travers des première (4a ; 40a) et deuxième (4b ; 40b) zones,
- un premier dispositif d'injection configuré pour injecter une première phase gazeuse de traitement dans la première zone (4a ; 40a) ainsi qu'un premier dispositif d'évacuation configuré pour évacuer la première phase gazeuse résiduelle (11d) hors de la première zone (4a ; 40a), et
- un deuxième dispositif d'injection configuré pour injecter une deuxième phase gazeuse de traitement dans la deuxième zone (4b ; 40b) ainsi qu'un deuxième dispositif d'évacuation configuré pour évacuer la deuxième phase gazeuse résiduelle (12d) hors de la deuxième zone (4b ; 40b).

2. Dispositif (10) selon la revendication 1, dans lequel la première zone (4a) s'étend le long d'un premier axe longitudinal (X₁) et dans lequel au moins un premier canal d'injection (180a) débouche dans la première zone (4a), ledit premier canal d'injection (180a) étant configuré pour injecter une partie au moins de la première phase gazeuse (11c) dans la première zone (4a) selon une première direction d'injection (D₁) non parallèle au premier axe longitudinal (X₁).

3. Dispositif (10) selon la revendication 2, dans lequel la première direction d'injection (D₁) forme un angle (α₁) compris entre 30° et 60° avec le premier axe longitudinal (X₁).

4. Dispositif (10) selon l'une quelconque des revendications 1 à 3, dans lequel la deuxième zone (4b) s'étend le long d'un deuxième axe longitudinal (X₂) et dans lequel au moins un deuxième canal d'injection (180b) débouche dans la deuxième zone (4b), ledit deuxième canal d'injection (180b) étant configuré pour injecter une partie au moins de la deuxième phase gazeuse dans la deuxième zone (4b) selon une deuxième direction d'injection (D₂) non parallèle au deuxième axe longitudinal (X₂).

5. Dispositif (10) selon la revendication 4, dans lequel la deuxième direction d'injection (D₂) forme un angle (α₂) compris entre 30° et 60° avec le deuxième axe longitudinal (X₂).

6. Dispositif (1) selon l'une quelconque des revendications 1 à 5, dans lequel la première zone (4a) s'étend le long d'un premier axe longitudinal (X₁) et dans lequel le premier dispositif d'injection présente des orifices d'injection (8a ; 8b) débouchant dans la première zone (4a), ces orifices d'injection (8a ; 8b) étant décalés le long du premier axe longitudinal (X₁).

7. Dispositif (1) selon l'une quelconque des revendications 1 à 6, dans lequel la deuxième zone (4b) s'étend le long d'un deuxième axe longitudinal (X₂) et dans lequel le deuxième dispositif d'injection présente des orifices d'injection (8d ; 8e) débouchant dans la deuxième zone (4b), ces orifices d'injection (8d ; 8e) étant décalés le long du deuxième axe longitudinal (X₂).

8. Dispositif (1; 10; 100) selon l'une quelconque des revendications 1 à 7, dans lequel la paroi est revêtue d'une couche réfléchissant le rayonnement infrarouge présentant un coefficient de réflexion moyen compris entre 5% et 50% sur le domaine de longueur d'onde compris entre 1000 nm et 8000 nm.

9. Dispositif (1; 10; 100) selon l'une quelconque des revendications 1 à 8, dans lequel le système de convoyage (6 ; 60) comporte un élément de réglage de la vitesse de défilement dudit au moins un fil (2) au travers de la chambre de traitement (4 ; 40).

10. Dispositif (1 ; 10) selon l'une quelconque des revendications 1 à 9, dans lequel la première zone (4a) entoure la deuxième zone (4b) et dans lequel la deuxième zone (4b) s'étend le long d'un deuxième axe longitudinal (X₂), le système de convoyage (6) comprenant plusieurs ensembles d'éléments de guidage (6a ; 6b ; 6c) positionnés de manière annulaire autour du deuxième axe longitudinal (X₂) et configurés pour positionner les fils (2) à traiter de manière circonférentielle dans chacune des première (4a) et deuxième zones (4b).

11. Procédé de revêtement d'un ou plusieurs fils (2) par un procédé de dépôt en phase vapeur mettant en oeuvre un dispositif (1 ; 10 ; 100) selon l'une quelconque des revendications 1 à 10, le procédé comportant au moins les étapes suivantes :
- injection de la première phase gazeuse dans la première zone (4a ; 40a) et de la deuxième phase gazeuse dans la deuxième zone (4b ; 40b),
- transport d'au moins un fil (2) par le système de convoyage (6 ; 60) dans la chambre de traitement (4 ; 40) durant lequel :
▪ ledit au moins un fil traverse la première zone (4a; 40a), respectivement la deuxième zone (4b ; 40b), afin de former une première couche sur ledit au moins un fil par dépôt en phase vapeur à partir de la première phase gazeuse, respectivement de la deuxième phase gazeuse, puis
▪ ledit au moins un fil revêtu de la première couche traverse la deuxième zone (4b ; 40b), respectivement la première zone (4a ; 40a), afin de former une deuxième couche sur ladite première couche par dépôt en phase vapeur à partir de la deuxième phase gazeuse, respectivement de la première phase gazeuse, et
- évacuation de la première phase gazeuse résiduelle (11d) hors de la première zone (4a; 40a) et de la deuxième phase gazeuse résiduelle (12d) hors de la deuxième zone (4b ; 40b).

12. Procédé selon la revendication 11, dans lequel ledit au moins un fil (2) est transporté en continu par le système de convoyage (6 ; 60) dans la chambre de traitement (4 ; 40).

13. Procédé selon l'une quelconque des revendications 11 et 12, dans lequel la première couche et/ou la deuxième couche sont formées par dépôt chimique en phase vapeur ou dépôt chimique en phase vapeur réactive.

14. Procédé selon l'une quelconque des revendications 11 à 13, dans lequel les première et deuxième couches sont chacune une couche d'un revêtement d'interphase.

15. Procédé de fabrication d'une pièce en matériau composite comportant au moins les étapes suivantes :
- revêtement d'une pluralité de fils par un revêtement d'interphase au moins par mise en oeuvre d'un procédé selon la revendication 14,
- formation d'une préforme fibreuse au moins par mise en oeuvre d'une ou plusieurs opérations textiles à partir des fils ainsi revêtus par le revêtement d'interphase, et
- densification de la préforme fibreuse par une matrice afin d'obtenir une pièce en matériau composite.

## Patentansprüche

1. Vorrichtung (1; 10; 100) zur Beschichtung von einem oder mehreren Fäden (2) durch ein Verfahren zur Gasphasenabscheidung, die mindestens umfasst:
- eine Behandlungskammer (4; 40), die mindestens eine erste Behandlungszone (4a; 40a) und eine zweite Behandlungszone (4b; 40b) definiert, in denen mindestens ein Faden (2) dazu bestimmt ist, durch die Umsetzung eines Verfahrens zur Gasphasenabscheidung beschichtet zu werden, wobei die erste und zweite Zone durch eine Wand (5; 50) getrennt sind und die erste Zone die zweite Zone umgibt oder über die zweite Zone gelegt ist,
- ein Fördersystem (6; 60), das dazu ausgestaltet ist, den Transport des mindestens einen Fadens (2) durch die erste (4a; 40a) und zweite (4b; 40b) Zone zu verwirklichen,
- eine erste Einspritzvorrichtung, die dazu ausgestaltet ist, eine erste Gasphase zur Behandlung in die erste Zone (4a; 40a) einzuspritzen, sowie eine erste Ablassvorrichtung, die dazu ausgestaltet ist, die verbleibende erste Gasphase (11d) aus der ersten Zone (4a; 40a) abzulassen, und
- eine zweite Einspritzvorrichtung, die dazu ausgestaltet ist, eine zweite Gasphase zur Behandlung in die zweite Zone (4b; 40b) einzuspritzen, sowie eine zweite Ablassvorrichtung, die dazu ausgestaltet ist, die verbleibende zweite Gasphase (12d) aus der zweiten Zone (4b; 40b) abzulassen.

2. Vorrichtung (10) nach Anspruch 1, wobei sich die erste Zone (4a) entlang einer ersten Längsachse (X₁) erstreckt und wobei mindestens ein erster Einspritzkanal (180a) in die erste Zone (4a) mündet, wobei der erste Einspritzkanal (180a) dazu ausgestaltet ist, zumindest einen Teil der ersten Gasphase (11c) in die erste Zone (4a) gemäß einer ersten Einspritzrichtung (D₁) einzuspritzen, die zu der ersten Längsachse (X₁) nicht parallel ist.

3. Vorrichtung (10) nach Anspruch 2, wobei die erste Einspritzrichtung (D₁) mit der ersten Längsachse (X₁) einen Winkel (α₁) zwischen 30° und 60° bildet.

4. Vorrichtung (10) nach einem der Ansprüche 1 bis 3, wobei sich die zweite Zone (4b) entlang einer zweiten Längsachse (X₂) erstreckt und wobei mindestens ein zweiter Einspritzkanal (180b) in die zweite Zone (4b) mündet, wobei der zweite Einspritzkanal (180b) dazu ausgestaltet ist, zumindest einen Teil der zweiten Gasphase in die zweite Zone (4b) gemäß einer zweiten Einspritzrichtung (D₂) einzuspritzen, die zu der zweiten Längsachse (X₂) nicht parallel ist.

5. Vorrichtung (10) nach Anspruch 4, wobei die zweite Einspritzrichtung (D₂) mit der zweiten Längsachse (X₂) einen Winkel (α₂) zwischen 30° und 60° bildet.

6. Vorrichtung (1) nach einem der Ansprüche 1 bis 5, wobei sich die erste Zone (4a) entlang einer ersten Längsachse (X₁) erstreckt und wobei die erste Einspritzvorrichtung Einspritzöffnungen (8a; 8b) aufweist, die in die erste Zone (4a) münden, wobei diese Einspritzöffnungen (8a; 8b) entlang der ersten Längsachse (X₁) versetzt sind.

7. Vorrichtung (1) nach einem der Ansprüche 1 bis 6, wobei sich die zweite Zone (4b) entlang einer zweiten Längsachse (X₂) erstreckt und wobei die zweite Einspritzvorrichtung Einspritzöffnungen (8d; 8e) aufweist, die in die zweite Zone (4b) münden, wobei diese Einspritzöffnungen (8d; 8e) entlang der zweiten Längsachse (X₂) versetzt sind.

8. Vorrichtung (1; 10; 100) nach einem der Ansprüche 1 bis 7, wobei die Wand mit einer Schicht beschichtet ist, welche die Infrarotstrahlung reflektiert und in dem Wellenlängenbereich zwischen 1000 nm und 8000 nm einen mittleren Reflexionskoeffizienten zwischen 5 % und 50 % aufweist.

9. Vorrichtung (1; 10; 100) nach einem der Ansprüche 1 bis 8, wobei das Fördersystem (6; 60) ein Element zur Regelung der Geschwindigkeit des Durchlaufs des mindestens einen Fadens (2) durch die Behandlungskammer (4; 40) umfasst.

10. Vorrichtung (1; 10) nach einem der Ansprüche 1 bis 9, wobei die erste Zone (4a) die zweite Zone (4b) umgibt und wobei sich die zweite Zone (4b) entlang einer zweiten Längsachse (X₂) erstreckt, wobei das Fördersystem (6) mehrere Einheiten von Führungselementen (6a; 6b; 6c) umfasst, die ringförmig um die zweite Längsachse (X₂) positioniert und dazu ausgestaltet sind, die zu behandelnden Fäden (2) umlaufend in jeder der ersten (4a) und zweiten Zone (4b) zu positionieren.

11. Verfahren zur Beschichtung von einem oder mehreren Fäden (2) durch ein Verfahren zur Gasphasenabscheidung, das eine Vorrichtung (1; 10; 100) nach einem der Ansprüche 1 bis 10 umsetzt, wobei das Verfahren zumindest die folgenden Schritte umfasst:
- Einspritzen der ersten Gasphase in die erste Zone (4a; 40a) und der zweiten Gasphase in die zweite Zone (4b; 40b),
- Transportieren von mindestens einem Faden (2) durch das Fördersystem (6; 60) in die Behandlungskammer (4; 40), währenddessen:
▪ der mindestens eine Faden die erste Zone (4a; 40a) bzw. die zweite Zone (4b; 40b) durchquert, um eine erste Schicht auf dem mindestens einen Faden durch Gasphasenabscheidung ausgehend von der ersten Gasphase bzw. der zweiten Gasphase zu bilden, dann
▪ der mindestens eine mit der ersten Schicht beschichtete Faden die zweite Zone (4b; 40b) bzw. die erste Zone (4a; 40a) durchquert, um eine zweite Schicht auf der ersten Schicht durch Gasphasenabscheidung ausgehend von der zweiten Gasphase bzw. der ersten Gasphase zu bilden, und
▪ Ablassen der verbleibenden ersten Gasphase (11d) aus der ersten Zone (4a; 40a) und der verbleibenden zweiten Gasphase (12d) aus der zweiten Zone (4b; 40b).

12. Verfahren nach Anspruch 11, wobei der mindestens eine Faden (2) kontinuierlich von dem Fördersystem (6; 60) in der Behandlungskammer (4; 40) transportiert wird.

13. Verfahren nach einem der Ansprüche 11 und 12, wobei die erste Schicht und/oder die zweite Schicht durch chemische Gasphasenabscheidung oder chemische reaktive Gasphasenabscheidung gebildet werden.

14. Verfahren nach einem der Ansprüche 11 bis 13, wobei die erste und zweite Schicht jeweils eine Schicht einer Interphasenbeschichtung sind.

15. Verfahren zur Herstellung eines Teils aus Verbundmaterial, das zumindest die folgenden Schritte umfasst:
- Beschichten von mehreren Fäden durch eine Interphasenbeschichtung zumindest durch die Umsetzung eines Verfahrens nach Anspruch 14,
- Bilden einer faserigen Vorform zumindest durch die Umsetzung von einem oder mehreren Textilvorgängen ausgehend von den auf diese Weise durch die Interphasenbeschichtung beschichteten Fäden, und
- Verdichten der faserigen Vorform durch ein Gesenk, um ein Teil aus Verbundmaterial zu erhalten.

## Claims

1. A device (1; 10; 100) for coating one or more yarns (2) by a vapor deposition method, the device comprising at least:
- a treatment chamber (4; 40) defining at least a first treatment zone (4a; 40a) and a second treatment zone (4b; 40b) in which at least one yarn (2) is to be coated by performing a vapor deposition method, the first and second zones being separated by a wall (5; 50) and the first zone surrounding the second zone, or being superposed on the second zone;
- a conveyor system (6; 60) configured to transport said at least one yarn (2) through the first and second zones (4a; 4b; 40a; 40b);
- a first injector device configured to inject a first treatment gas phase into the first zone (4a; 40a) and a first removal device configured to remove the residual first gas phase (11d) from the first zone (4a; 40a); and
- a second injector device configured to inject a second treatment gas phase into the second zone (4b; 40b), and a second removal device configured to remove the residual second gas phase (12d) from the second zone (4b; 40b).

2. A device (10) according to claim 1, wherein the first zone (4a) extends along a first longitudinal axis (X₁) and wherein at least a first injection channel (180a) opens out into the first zone (4a), said first injection channel (180a) being configured to inject at least a portion of the first gas phase (11c) into the first zone (4a) along a first injection direction (D₁) that is not parallel to the first longitudinal axis (X₁).

3. A device (10) according to claim 2, wherein the first injection direction (D₁) forms an angle (α₁) lying in the range 30° to 60° with the first longitudinal axis (X₁).

4. A device (10) according to any one of claims 1 to 3, wherein the second zone (4b) extends along a second longitudinal axis (X₂) and wherein at least one second injection channel (180b) opens out into the second zone (4b), said second injection channel (180b) being configured to inject at least a portion of the second gas phase into the second zone (4b) along an injection direction (D₂) that is not parallel to the second longitudinal axis (X₂).

5. A device (10) according to claim 4, wherein the second injection direction (D₂) forms an angle (α₂) lying in the range 30° to 60° with the second longitudinal axis (X₂).

6. A device (1) according to any one of claims 1 to 5, wherein the first zone (4a) extends along a first longitudinal axis (X₁) and wherein the first injector device presents injection orifices (8a; 8b) opening out into the first zone (4a), these injection orifices (8a; 8b) being offset along the first longitudinal axis (X₁).

7. A device (1) according to any one of claims 1 to 5, wherein the second zone (4b) extends along a second longitudinal axis (X₂) and wherein the second injector device presents injection orifices (8d; 8e) opening out into the second zone (4b), these injection orifices (8d; 8e) being offset along the second longitudinal axis (X₂).

8. A device (1; 10; 100) according to any one of claims 1 to 7, wherein the wall is coated in a layer that reflects infrared radiation and that presents a mean coefficient of reflection lying in the range 5% to 50% over the wavelength range 1000 nm to 8000 nm.

9. A device (1; 10; 100) according to any one of claims 1 to 8, wherein the conveyor system (6; 60) includes an element for adjusting the travel speed of said at least one yarn (2) through the treatment chamber (4; 40).

10. A device (1; 10) according to any one of claims 1 to 9, wherein the first zone (4a) surrounds the second zone (4b) and wherein the second zone (4b) extends along a second longitudinal axis (X₂), the conveyor system (6) having a plurality of sets of guide elements (6a; 6b; 6c) positioned in annular manner around the second longitudinal axis (X₂) and configured to position the yarns (2) for treatment in circumferential manner in each of the first and second zones (4a; 4b).

11. A method of coating one or more yarns (2) by a vapor deposition method by using a device (1; 10; 100) in accordance with any one of claims 1 to 10, the method comprising at least the following steps:
- injecting the first gas phase into the first zone (4a; 40a) and the second gas phase into the second zone (4b; 40b);
- transporting at least one yarn (2) by means of the conveyor system (6; 60) through the treatment chamber (4; 40), during which:
- said at least one yarn passes through either the first zone (4a; 40a) or the second zone (4b; 40b) so as to form a first layer on said at least one yarn by vapor deposition respectively from the first gas phase or from the second gas phase; and then
- said at least one yarn coated in the first layer passes through the second zone (4b; 40b) or the first zone (4a; 40a) so as to form a second layer on said first layer by vapor deposition respectively from the second gas phase or from the first gas phase; and
- removing the residual first gas phase (11d) from the first zone (4a; 40a) and the residual second gas phase (12d) from the second zone (4b; 40b).

12. A method according to claim 11, wherein said at least one yarn (2) is transported continuously by the conveyor system (6; 60) through the treatment chamber (4; 40).

13. A method according to claim 11 or claim 12, wherein the first layer and/or the second layer is/are formed by chemical vapor deposition or by reactive chemical vapor deposition.

14. A method according to any one of claims 11 to 13, wherein each of the first and second layers comprises an interphase coating layer.

15. A method of fabricating a composite material part, the method comprising at least the following steps:
- coating a plurality of yarns with an interphase coating at least by performing a method according to claim 14;
- forming a fiber preform at least by performing one or more textile operations on yarns coated in this way with the interphase coating; and
- densifying the fiber preform with a matrix in order to obtain a composite material part.
